Europäisches Patentamt

European Patent Office

Office européen des brevets

(11) Publication number: 0 464 667 A2

# EUROPEAN PATENT APPLICATION

(21) Application number: 91110651.6

(22) Date of filing: 27.06.91

(51) Int. Cl.⁵: H03K 17/22

(30) Priority: 28.06.90 JP 171212/90

(43) Date of publication of application:
08.01.92 Bulletin 92/02

(84) Designated Contracting States:
DE FR GB

(71) Applicant: Kabushiki Kaisha Toshiba
72, Horikawa-cho Saiwai-ku
Kawasaki-shi(JP)

Applicant: TOSHIBA MICRO-ELECTRONICS
CORPORATION
25-1, Ekimaehoncho
Kawasaki-ku Kawasaki-shi(JP)

(72) Inventor: Hashimoto, Hisashi, c/o Intellectual
Property Div., K.K. Toshiba, 1-1 Shibaura,
1-chome, Minato-ku, Tokyo 105(JP)
Inventor: Kato, Toshiya
Intell.Prop.Div.,K.K.Toshiba ,1-1 Shibaura,1
chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) Power-on-clear signal generating circuit.

(57) The gate of an enhancement type N-channel MOS transistor (23) is connected to the drain of a P-channel MOS transistor (22), which serves as a load element. The source and drain of the N-channel MOS transistor (23) is connected to the ground voltage GND. The input terminal of a Schmitt trigger circuit (25) is the connection node which connects the drain of the P-channel MOS transistor (22) and the gate of the N-channel MOS transistor (23) to each other. The output terminal (26) from which a power-on-clear signal (POC) is output is connected to the output terminal of the Schmitt trigger circuit (25).

FIG. 2

The present invention relates to a power-on-clear signal generating circuit which generates a power-on-clear signal when the power is turned on.

In a semiconductor integrated circuit device, the internal status (how it has been set) of the resistor, etc. thereof cannot be observed at the time when the power is turned on; therefore, the internal state of the resistor, etc. having been set so, is reset upon turning on the power by a power-on-clear signal generated from the power-on-clear signal generating circuit usually provided in the IC device.

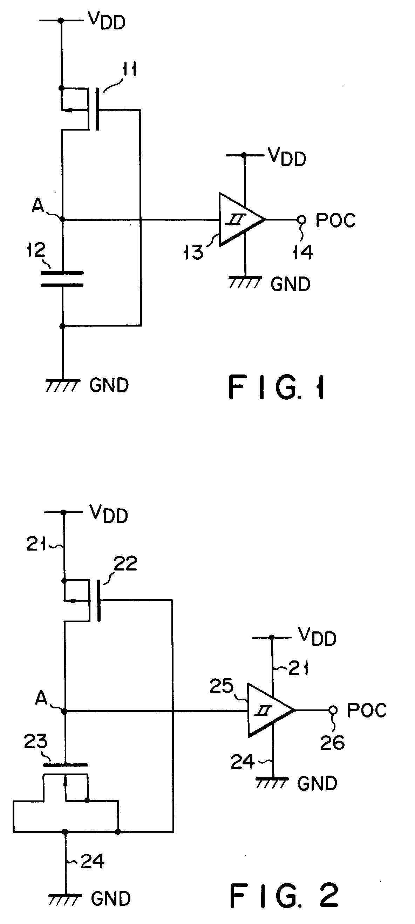

Fig. 1 depicts a conventional power-on-clear signal generating circuit. As can be seen in this figure, the source-drain path of a P-channel MOS transistor 11, and a capacitor 12 is connected in series and inserted between a node to which a power voltage VDD is applied and another node to which a ground voltage GND is applied. The gate of the MOS transistor 11 is connected to the GND node, and this transistor 11 is conductive at any time.

The following is an explanation of the operation of a circuit having such a conventional structure.

When the power is turned on, a drain current flows into the MOS transistor 11, and thus charging of the capacitor 12 is initiated when the current starts to flow thereinto. As the capacitor is charged, the potential of the node A increases, accordingly. When such a voltage of the node A exceeds the circuit threshold voltage of the Schmitt trigger circuit 13, the output potential, i.e., the level of the power-on-clear signal POC, is inverted from the prior level, thereby releasing a clear status of the resistor, etc.

It should be noted that the above capacitor 12 is provided so as to set a delay time, which is defined as a time period between the turning-on of the power and the inversion of the level of a power-on-clear signal POC.

Conventionally, the capacitor 12 is composed of a depression type MOS transistor; therefore, its capacitance is fixed. With such a capacitor, if the value of a power voltage VDD varies, the time required for charging the capacitor 12 changes, accordingly. As a result, the time required for the potential of the node A to reach the circuit threshold voltage of the Schmitt trigger circuit 13 varies, affecting a predetermined power-on-clear time period set by the capacitor 12. For example, if the value of the power voltage VDD drops, the drain current of the MOS transistor 11 decreases, accordingly, thereby delaying the rising of the potential of the node A while the capacitor 12 is being charged. This results in prolongation of the power-on-clear time period, and in some cases, the time period is prolonged twice as long as the set value, depending on the variance of the power voltage VDD.

The present invention has been achieved in consideration of the above, and the purpose thereof is to provide a power-on-clear signal generating circuit which can maintain its power-on-clear time period at approximately constant all the time even if the power voltage varies.

According to the present invention, there is provided a power-on-clear signal generating circuit comprising the first power source node to which the first power source voltage is applied, the second power source node to which the second power source voltage is applied, a load element an end of which is connected to the first power source node, and the first MOS transistor of the enhancement type, a gate of which is connected to an other end of said load element, and a source and drain of which are connected to the second power source node.

Further, according to the invention, there is also provided a power-on-clear signal generating circuit comprising the first power source node to which the first power source voltage is applied, the second power source node to which the second power source voltage is applied, the load element an end of which is connected to the first power source node, the first MOS transistor of the enhancement type, a gate of which is connected to an other end of said load element, and a source and drain of which are connected to said second power source node, and a signal generating circuit for outputting a power-on-clear signal, an input terminal of which is connected to a connection node between said load element and the gate of said first MOS transistor so as to receive a signal from the connection node at a predetermined circuit threshold voltage.

This invention can be more fully understood from the following detailed description when taken in conjunction with the accompanying drawings, in which:

Fig. 1 is a diagram of a conventional circuit;

Fig. 2 is a circuit diagram of the first embodiment of the present invention;

Fig. 3 illustrates the waveforms of outputs from the circuit of the first embodiment;

Fig. 4 is a cross section of a MOS transistor employed in the circuit of the first embodiment, this cross section being designed to help an explanation of the element structure of the transistor;

Fig. 5 illustrates the characteristics of the MOS transistor shown in Fig. 4;

Fig. 6 is a detailed circuit diagram of the Schmitt trigger circuit employed in the first embodiment;

Fig. 7 is a circuit diagram showing the second embodiment of the present invention; and

Fig. 8 is a circuit diagram showing the third embodiment of the present invention.

The embodiments of the present invention will now be described in detail with reference to the accompanying drawings.

Fig. 2 shows the structure of the first embodiment of the power-on-clear signal generating circuit according to the present invention. As can be seen in this figure, the source and the back gate of an enhancement type P-channel MOS transistor 22, which functions as a load element, are connected to a node 21 to which a positive power voltage VDD is applied, and the gate of an enhancement type N-channel MOS transistor 23, which functions as a capacitor, is connected to the drain of the MOS transistor 22. All of the source, drain, and back gate of the MOS transistor 23 are connected to a node 24 to which a ground voltage GND is applied. Further, the gate of the MOS transistor 22 is connected to the node 24 of the ground voltage GND; therefore the MOS transistor 22 is at any time conductive.

Moreover, the input terminal of the Schmitt trigger circuit 25 is connected to the node A to which the drain of the MOS transistor 22 and the gate of the MOS transistor 23 are connected. The output terminal of the Schmitt trigger circuit 25 is connected to an output terminal 26 for outputting a power-on-clear signal POC. In addition, a power voltage VDD of the positive polarity type and a ground voltage GND are supplied also to the Schmitt trigger circuit 25.

The following is an explanation of the operation of a circuit having the above-described structure.

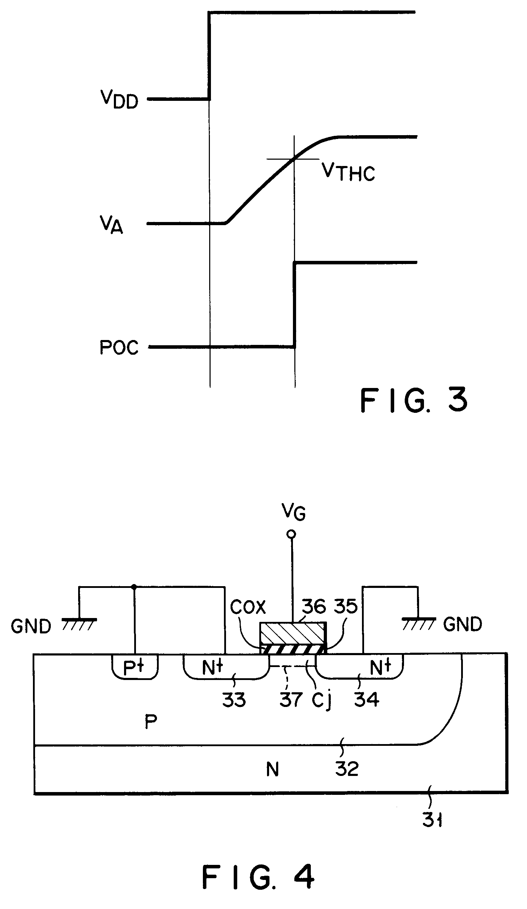

When the power is turned on, and a positive polar power voltage VDD rises, the waveform of which is shown in Fig. 3, the MOS transistor 22 becomes conductive and a drain current flows thereinto. The flow of the drain current initiates the charging of the capacitor which is located at the gate of the MOS transistor 23 to parasitize it. As the current flows, the node A potential VA increases, accordingly. When the potential VA exceeds the circuit threshold voltage VTHC of the Schmitt trigger circuit 25, the output potential from the Schmitt trigger circuit 25, i.e. the level of the power-on-clear signal POC, is inverted from a prior "L" level to a "H" level, thereby releasing a clear status of the resistor, etc.

In a circuit such as a resistor, to which the power-on-clear signal POC is supplied, the internal status of such a resistor is reset while the signal POC is at the "L" level, and when the signal POC is inverted to the "H" level, the resistor starts to carry out the regular operation.

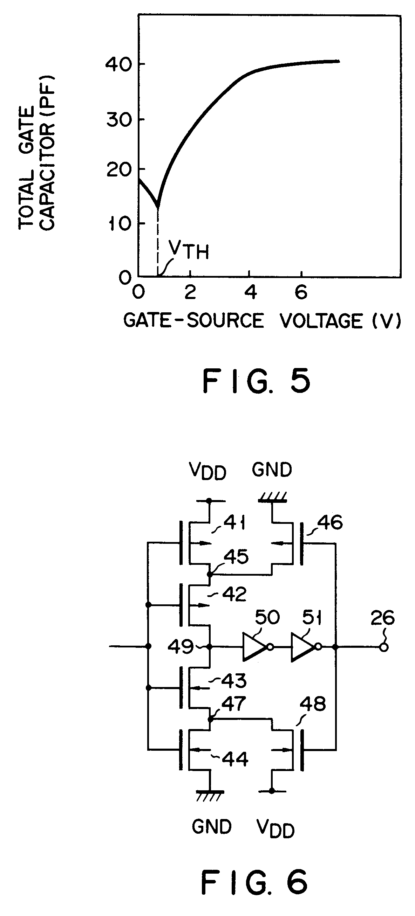

The gate capacitor located at the gate of the MOS transistor 23 to parasitize it, will now be explained with reference to Figs. 4 and 5.

Fig. 4 shows the structure of the enhancement type N-channel MOS transistor 23, illustrating an N type semiconductor substrate 31, and p type well region 32. In this P type well region 32, a source region 33 and a drain region 34 both of which are $N^+$ type diffusion regions are formed as they are apart from each other. Further, on the channel region located between the source regions 33 and the drain region 34, a gate electrode conductor 36 is provided indirectly via a gate insulation film 35.

With the MOS transistor having such a structure, when a positive polar potential VG is supplied to the gate electrode conductor 36, a depletion layer 37 is created in the channel region. It should be noted here that Fig. 4 depicts the transistor before an inversion layer is formed in its channel region. Since a carrier is not present in the depletion layer 37, it can be regarded as an insulation layer 37. Further, the gate capacitor of the MOS transistor 23 can be regarded as a combination of a capacitor Cj, i.e. the depletion layer 37 and a capacitor Cox, i.e. the gate insulation film 35. In the meantime, expansion of the depletion layer 37 depends on the level of the potential VG supplied to the gate electrode conductor 36. When the potential VG increases and exceeds the threshold voltage of the MOS transistor 23, an inversion layer is formed in the depletion layer 37. The capacitance of the capacitor Cj, that is, the depletion layer 37, varies in accordance with the potential VG. The variance of the gate capacitance of the total gate capacitor (capacitors Cj and Cox) is plotted against the gate-source voltage on a graph shown in Fig. 5. As can be seen in this graph, the total gate capacitor (capacitors Cj and Cox) continuously decreases from where the gate-source voltage VGS of the MOS transistor 23 is 0V to where that reaches threshold voltage VTH. Such a phenomenon occurs because the capacitance of the capacitor Cox, i.e. the gate insulation film 35, is fixed but the capacitance of the capacitor Cj, i.e. the depletion layer 37, decreases. When the gate-source voltage VGS exceeds the threshold voltage VTH, the inversion layer is created in the depletion layer 37; therefore as the voltage VGS rises, the capacitance of the capacitor Cj starts to increase. The following is an explanation of such a phenomenon with reference to Fig. 4. To-be-inversion-layer portions formed in the depletion layer 37 at both source and drain regions 33 and 34 sides expand from both sides, gradually eroding the depletion layer 37. When these portions meet with each other, the increase in the capacitance of the capacitor Cj substantially stops, and the gate capacitor (Cox + Cj) is saturated.

In the power-on-clear signal generating circuit shown in Fig. 2, as the power voltage VDD varies, the drain current flowing into the MOS transistor 22 varies, accordingly. The rate of variance of the drain current into the MOS transistor 22 due to the variance of the power voltage VDD is significantly higher than that of the circuit threshold voltage of the Schmitt trigger circuit 25.

Let us now take an example in which the power voltage VDD drops below the standard value. In this case, the gate-source voltage of the MOS transistor 22 drops, and the drain current decreases. Consequently, the rising speed of the gate potential of the MOS transistor 23 becomes slower than in the case where the power voltage is at the standard level. Further, the gate capacitance of the MOS transistor 23 varies in accordance with the rise of the gate potential, as can be seen in Fig. 5. In other words, in the case where the gate voltage is the same as or higher than the MOS transistor's threshold voltage VTH, the gate capacitance decreases. Because of this decrease in the gate capacitance (Cox + Cj) of the MOS transistor 23, the time required until the potential of the node A reaches the circuit threshold voltage of the Schmitt trigger circuit 25 from the point of turning on of the power, does not deviates from that of the case where the power voltage is at the standard level, despite that the power voltage VDD drops and the drain current of the MOS transistor 22 decreases.

On the other hand, in the case where the power voltage VDD rises higher than the standard value, the gate-source voltage of the MOS transistor 22 increases, and so does the drain current, accordingly.

Therefore, the time required until the potential of the node A reaches the circuit threshold voltage of the Schmitt trigger circuit 25 from the point of turning on of the power also does not deviate from that of the case where the power voltage is at the standard level.

Thus, a substantially constant power-on-clear time period is obtained at any time.

Fig. 6 shows a detailed structure of a Schmitt trigger circuit 25 employed in the above embodiment. In this circuit, the source-drain paths of two P-channel MOS transistors 41 and 42, and two N-channel MOS transistors 43 and 44 are inserted in series between a node to which a positive polar power potential VDD is applied, and another node to which a ground voltage GND is applied. Further, the gates of the MOS transistors 41-44 are connected in common with each other to make the input terminal of this Schmitt trigger circuit.

The source-drain path of a P-channel MOS transistor 46 is inserted between a connection node 45 for connecting the MOS transistors 41 and 42 in series to each other and a node to which a ground voltage GND is applied, whereas the source-drain path of the N-channel MOS transistor 48 is inserted between a connection node 47 for connecting the MOS transistors 43 and 44 in series to each other and a node to which a power voltage VDD is applied. Further, an input terminal of an inverter 50 is connected to the series connection node 49 of the MOS transistors 42 and 43, and this output terminal is connected to a input terminal of an inverter 51. An output terminal of the inverter 51 is connected to an output terminal 26 from where the power-on-clear signal POC is output, and the gates of both MOS transistors 46 and 48 are connected to the output terminal of the inverter 51.

The Schmitt trigger circuit having such a structure is well-known in the field of the semiconductor integrated circuit devices. In a Schmitt trigger circuit, a circuit threshold voltage VTHCH at which an input signal raises its level from "L" to "H", differs from a circuit threshold voltage VTHCL at which an input signal lowers its level from "H" to "L", and more specifically, the circuit threshold voltage VTHCH is higher than the circuit threshold voltage VTHCL.

With these two kinds of circuit threshold voltages, malfunction of the circuit, which is likely to be caused by noise contained in an input signal, can be prevented.

According to the first embodiment, the power-on-clear signal generating circuit employs the enhancement type MOS transistor 23 as a capacitor. With this technical idea, when an entire circuit is formed on a semiconductor substrate, the MOS transistor 23 can be formed through a process similar to those for the other enhancement type MOS transistors of the circuit. Therefore, manufacture of such a circuit can be conducted without adding any extra process to the conventional manufacturing method. Thus, the above embodiment is a very advantageous circuit consisting of enhancement type MOS transistors, which is presently most available.

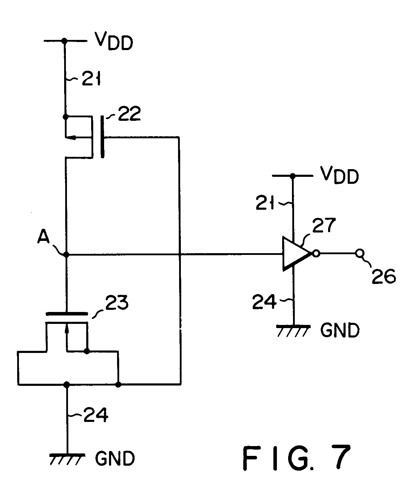

Furthermore, the second embodiment of the present invention is depicted in Fig. 7, in which an inverter 27 is employed in place of the Schmitt trigger circuit 25 in the first embodiment, to generate a power-on-clear signal POC in accordance with a signal from the node A.

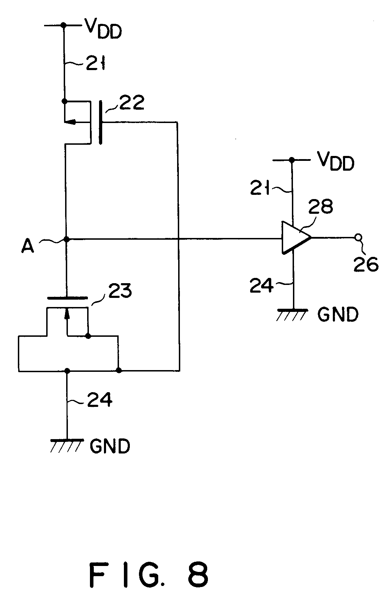

Furthermore, the third embodiment of the present invention is depicted in Fig. 8, in which a buffer circuit 28 is employed in place of the Schmitt trigger circuit 25 in the first embodiment, to generate a power-on-clear signal POC in accordance with a signal from the node A.

In addition, the present invention is of course not limited to the above-mentioned two embodiments, and can be remodeled into a variety of circuits. For example, in the embodiments, the enhancement type MOS transistor 22 is used as a load element; however resistors, etc. can be used as such a load element in place of the MOS transistors.

Thus, according to the present invention, there is provided a power-on-clear signal generating circuit which is able to maintain a substantially constant clear time period at any time if a power voltage varies.

**Claims**

**1.** A power-on-clear signal generating circuit comprising:

a first power source node (21) to which a first power source voltage (VDD) is applied;

a second power source node (24) to which a second power source voltage is applied;

a load element (22), an end of which is connected to said first power source node; and

a first MOS transistor (23) of an enhancement type, a gate of which is connected to an other end of said load element, and a source and drain of which are connected to said second power source node.

**2.** A power-on-clear signal generating circuit according to claim 1, characterized in that said load element is composed of a second MOS transistor (22) of an enhancement type, and includes a gate, source, and drain connected to the second power source node, the first power source node, and the gate of said first MOS transistor, respectively.

**3.** A power-on-clear signal generating circuit according to claim 1, characterized in that said first MOS transistor is of an N channel type.

**4.** A power-on-clear signal generating circuit according to claim 2, characterized in that said second MOS transistor is of a P channel type.

**5.** A power-on-clear signal generating circuit comprising:

a first power source node (21) to which a first power source voltage (VDD) is applied;

a second power source node (24) to which a second power source voltage is applied;

a load element (22), an end of which is connected to said first power source node;

a first MOS transistor (23) of an enhancement type, a gate of which is connected to an other end of said load element, and a source and drain of which are connected to said second power source node; and

a signal generating circuit (25,27) for outputting a power-on-clear signal, an input terminal of which is connected to a connection node between said load element and the gate of said first MOS transistor so as to receive a signal from the connection node at a predetermined circuit threshold voltage.

**6.** A power-on-clear signal generating circuit according to claim 5, characterized in that said load element is composed of a second MOS transistor (22) of an enhancement type, and includes a gate, source, and drain connected to the second power source node, the first power source node, and the gate of said first MOS transistor, respectively.

**7.** A power-on-clear signal generating circuit according to claim 5, characterized in that said first MOS transistor is of an N channel type.

**8.** A power-on-clear signal generating circuit according to claim 6, characterized in that said second MOS transistor is of a P channel type.

**9.** A power-on-clear signal generating circuit according to claim 5, characterized in that said signal generating circuit is a Schmitt trigger circuit.

**10.** A power-on-clear signal generating circuit according to claim 5, characterized in that said signal generating circuit is an inverter (27).

**11.** A power-on-clear signal generating circuit according to claim 5, characterized in that said signal generating circuit is a buffer circuit (28).

FIG. 1

FIG. 2

$V_{DD}$

$V_A$

$V_{THC}$

POC

# FIG. 3

$V_G$

GND

COX    36  35    GND

$P^+$    $N^+$    $N^+$

33    37 Cj    34

P

N    32

31

# FIG. 4

F I G. 5

F I G. 6

FIG. 7

FIG. 8